# EUROPEAN PATENT APPLICATION

(11) **EP 4 791 144 A1**
(43) Date of publication of application: **12.08.2026**
(21) Application number: 25216203.7
(22) Date of filing: 17.11.2025
(51) Int. Cl.: H10D 30/01, H10D 30/66, H10D 62/13, H10D 62/17, H10D 64/00, H10D 64/27

(54) **STRUCTURES AND METHODS FOR SELF-ALIGNED GATE-DRAIN OVERLAP TRENCH MOSFETS**

(30) Priority: 10.02.2025 US 202519049603
(71) Applicant: Semiconductor Components Industries, LLC, Scottsdale, AZ 85250 (US)
(72) Inventor: SOMA, Mitsuru, Higashimatsuyama, Saitama, 355-0048 (JP)
(74) Representative: Manitz Finsterwald Patent- und Rechtsanwaltspartnerschaft mbB

(57) **Abstract**

A self-aligned gate-drain overlap trench MOSFET includes a trench gate structure that includes a trench extending from the first major surface into the region of semiconductor material, a shield dielectric layer adjacent to a lower portion of the trench, and a shield electrode adjacent to the shield dielectric layer in the lower portion of the active trench. The gate electrode includes a second polycrystalline semiconductor material, a gate conductive layer adjacent to the gate electrode, and a dielectric fill structure in the trench electrically isolating the gate electrode and the gate conductive layer from the shield electrode. The body region has a bottom edge, and the width of the body region above the bottom edge is substantially greater than a width of the semiconductor material below the bottom edge.

## Description

### TECHNICAL FIELD

The disclosure relates, in general, to electronics and, more particularly, to semiconductor device structures and methods of forming semiconductor devices.

### BACKGROUND

Currently known semiconductor devices and methods for forming semiconductor devices, such as metal-oxide-semiconductor field-effect transistors (MOSFETs), are unsatisfactory in a number of respects. For example, such devices may exhibit decreased reliability, excessive cost, relatively low performance (e.g., unsatisfactory switching performance), reduced manufacturability, high processes variation, and/or suboptimal packing density.

Further limitations and disadvantages of conventional and traditional approaches will become apparent to one of ordinary skill in the art through comparison of such approaches with the present disclosure and reference to the drawings.

### BRIEF DESCRIPTION OF THE DRAWINGS

Embodiments are described with reference to the appended drawing figures, in which like numerals denote like elements, and:
FIG. 1 illustrates a partial cross-sectional view of a semiconductor device in accordance with the present description;
FIG. 2 is a close-up of a portion of the partial cross-sectional view of FIG. 1;
FIG. 3 is a flowchart depicting a method for fabricating a semiconductor device in accordance with the present description; and
FIGS. 4-12 are partial cross-sectional views illustrating intermediate states of a method of manufacturing a semiconductor device in accordance with the present description.

### DETAILED DESCRIPTION

Metal-oxide-semiconductor field-effect transistors (MOSFETs) are often employed in applications that require high switching speeds, low power consumption, and high input impedance. Modern MOSFETs may incorporate a trench structure that provides several benefits over traditional planar MOSFETs, such as significantly lower on-resistance (R_{DS(ON)}), improved switching performance, and higher power density. The presence of the trench structure results in lower gate charge (Q_{g}) and reduced Miller capacitance, further minimizing switching losses. These benefits are achieved, in part, by the vertical orientation of the MOS interface, which allows for a more compact design, a reduction in the lateral dimensions of the device ("lateral shrink"), and increased current-carrying channels per unit area.

Further performance improvements in trench MOSFET semiconductor devices can be achieved through the use of a shielded-gate structure in which a vertically oriented shield electrode is electrically coupled to the source electrode. The shield electrode, along with the thicker oxide between the electrode and the drift region, provide charge balance and enables higher doping in the drift region, thereby reducing both on-resistance and gate charge.

Despite recent advances, currently known trench MOSFET designs are unsatisfactory in a number of respects. For example, conventional trench MOSFETs remain prone to significant gate-drain overlap - i.e., regions in which the gate electrode is directly adjacent to the drain region of the MOSFET and separated only by the gate oxide. This overlap significantly contributes to the parasitic gate-drain overlap capacitance (C_{gd}), which can result in switching losses and increased power dissipation.

As trench MOSFETs are scaled down, maintaining precise control over gate-drain overlap becomes more challenging. Significant variations in gate-drain overlap in shielded-gate trench MOSFETs can result from a variety of process variations, such as shield poly recess, shield oxide recess, and inter-poly-oxide recess etching, which together can significantly affect the gate electrode bottom position and other geometrical features of the gate and trench regions.

Accordingly, there is a long-felt need for shielded-gate trench MOSFET structures and methods that reduce or eliminate gate-drain overlap and thereby reduce parasitic gate-drain capacitance and switching losses. There is also a need for shielded-gate trench MOSFET designs that are cost-effective, have a high packing density (e.g., lateral shrink), and at the same time reduce the impact of process variation on gate-drain overlap and its deleterious effects.

In general, the present description relates to semiconductor device structures and methods of making semiconductor devices that reduce gate-drain overlap in shielded-gate trench FETs through the use of self-aligned structures during the fabrication process.

More particularly, in accordance with one embodiment, a semiconductor device includes a region of semiconductor material comprising a first major surface and having a first conductivity type, and a trench gate structure. The trench gate structure includes: a trench extending from the first major surface into the region of semiconductor material; a shield dielectric layer adjacent to a lower portion of the trench; a shield electrode adjacent to the shield dielectric layer in the lower portion of the active trench, the shield electrode comprising a first polycrystalline semiconductor material; a gate dielectric layer adjacent to an upper portion of the trench; a gate electrode adjacent to the gate dielectric layer in the upper portion of the active trench, the gate electrode comprising a second polycrystalline semiconductor material; a gate conductive layer adjacent to the gate electrode; and a dielectric fill structure in the trench electrically isolating the gate electrode and the gate conductive layer from the shield electrode. The semiconductor device further includes a body region of a second conductivity type opposite that of the first conductivity type in the region of semiconductor material extending from the major surface adjacent to the trench gate structure, wherein the body region has a bottom edge, and the width of the body region above the bottom edge is substantially greater than a width of the semiconductor material below the bottom edge. The semiconductor device further includes a source region of the first conductivity type adjacent to the body region. In some embodiments, the gate electrode includes a laterally extending region below the bottom edge of the body region. In some embodiments, the gate electrode below the bottom edge of the body region is separated from the semiconductor material by a lateral distance that is greater than the thickness of the gate dielectric layer (e.g., approximately equal to the thickness of the shield dielectric layer). In accordance with one embodiment, the body region comprises at least a portion of epitaxially grown semiconductor material. In accordance with one embodiment, the body region includes an overhang region relative to the semiconductor material below the bottom edge of the body region.

A method of forming a semiconductor device in accordance with one embodiment includes providing a region of semiconductor material comprising a first major surface and a first conductivity type and a trench gate structure. The trench gate structure includes: a trench extending from the first major surface into the region of semiconductor material; a shield dielectric layer adjacent to a lower portion of the active trench; a shield electrode adjacent to the shield dielectric layer, the shield electrode comprising a first polycrystalline semiconductor material; a gate dielectric layer adjacent to an upper portion of the active trench; a gate electrode adjacent to the gate dielectric layer, the gate electrode comprising a second polycrystalline semiconductor material; a gate conductive layer adjacent to the gate electrode; and a dielectric fill structure in the active trench electrically isolating the gate electrode and the gate conductive layer from the shield electrode. The method further includes providing a body region of a second conductivity type opposite the first conductivity types in the region of semiconductor material extending from the major surface adjacent to the trench gate structure. The body region has a bottom edge, and the width of the body region above the bottom edge is substantially greater than a width of the semiconductor material below the bottom edge. The method further includes providing a source region of the first conductivity type in the body region adjacent to the trench gate structure.

A semiconductor device in accordance with one embodiment comprises: a region of semiconductor material comprising a first major surface and a first conductivity type and a trench gate structure. The trench gate structure comprises: a trench extending from the first major surface into the region of semiconductor material; a shield dielectric layer adjacent to a lower portion of the trench; a shield electrode adjacent to the shield dielectric layer in the lower portion of the active trench, the shield electrode comprising a first polycrystalline semiconductor material; a gate dielectric layer adjacent to an upper portion of the trench; a gate electrode adjacent to the gate dielectric layer in the upper portion of the active trench, the gate electrode comprising a second polycrystalline semiconductor material; a gate conductive layer adjacent to the gate electrode; a dielectric fill structure in the trench electrically isolating the gate electrode and the gate conductive layer from the shield electrode; a body region of a second conductivity type opposite that of the first conductivity type in the region of semiconductor material extending from the major surface adjacent to the trench gate structure, wherein the body region comprises at least a portion of epitaxially grown semiconductor material forming a semiconductor mesa overhang region such that a width of the body region above the semiconductor mesa overhang region is substantially greater than a width of the semiconductor material below the semiconductor mesa overhang region; and a source region of the first conductivity type adjacent to the body region.

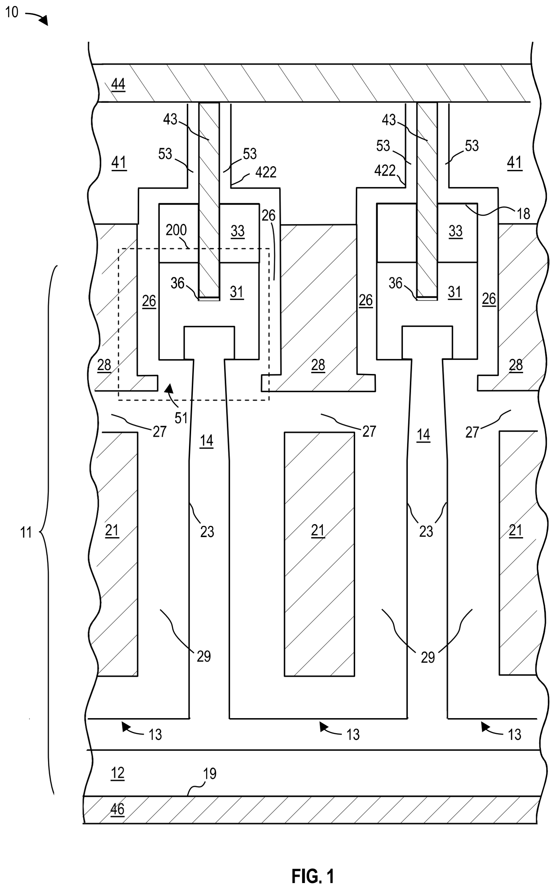

FIG. 1 illustrates a partial cross section of a semiconductor device 10 (also referred to as an "electronic device," "shielded-gate trench MOSFET," or simply "MOSFET") having a shielded gate structures 13 with certain self-aligned geometric features in accordance with various embodiments of the present description.

In some embodiments, shielded-gate trench structures 13 are placed in an active region of semiconductor device 10; in other embodiments, semiconductor device 10 includes semiconductor material (or "work piece") 11, such as a region of semiconductor material having a major surface 18 and an opposing major surface 19. In some embodiments, major surface 18 is configured as an active surface of semiconductor device 10.

In the illustrated embodiment, semiconductor material 11 includes a bulk semiconductor substrate 12, such as an N-type conductivity silicon substrate having a resistivity in a range of about 0.001 ohm-cm to about 0.005 ohm-cm. Substrate 12 may be doped with, for example, phosphorous, arsenic, or antimony. In the illustrated embodiment, substrate 12 includes a drain contact (or "first current carrying contact") for semiconductor device 10 corresponding to major surface 19.

Semiconductor material 11 further includes a semiconductor layer 14 (also referred to as "doped region," "doped layer," or "doped layers"), which can be formed in, on, or overlying substrate 12. In one embodiment, semiconductor layer 14 is an N-type conductivity region or layer when substrate 12 is N-type conductivity, and can be formed using epitaxial growth techniques, ion implantation, and diffusion techniques, and/or other combinations thereof known to one of ordinary skill in the art. In one embodiment, semiconductor layer 14 includes major surface 18 of semiconductor material 11. It will be understood, however, that semiconductor material 11, substrate 12, and/or semiconductor layer 14 may include other types of materials and structures, including, but not limited to, heterojunction semiconductor materials, SiGe, SiGeC, SiC, GaN, AlGaN, and/or other such materials known to one of ordinary skill in the art.

In some embodiments, semiconductor layer 14 has a dopant concentration that is less than the dopant concentration of substrate 12. The dopant concentrations and thicknesses of semiconductor layer 14 may be increased or decreased depending, for example, on the desired breakdown (BV_{DSS}) rating and the layer design of semiconductor device 10. In some embodiments, semiconductor layer 14 has a dopant profile that varies linearly or non-linearly (e.g., exponentially) with respect to depth inward (i.e., downward with respect to FIG. 1) from major surface 18.

In the illustrated embodiment, shielded gate trench structure 13 includes an active trench 23 extending from major surface 18 inward to a depth within semiconductor layer 14. Shielded gate trench structure 13 further includes a shield electrode 21, a shield dielectric layer 29 separating shield electrode 21 from semiconductor layer 14, a gate dielectric 26 over upper surfaces of active trench 23, gate electrodes 28 disposed adjacent to gate dielectric 26, and an interlayer dielectric (ILD) (or "inter-pad dielectric") 27 electrically isolating shield electrode 21 from gate electrode 28.

In some embodiments, shield dielectric layer 29 comprises a thermal oxide having a thickness in a range of about 800 Å to about 1050 Å. The thickness of shield dielectric layer 29 may be made thicker or thinner depending on, for example, the desired electrical characteristics of semiconductor device 10. For example, the thickness of shield dielectric layer 29 may be increased for higher voltage devices (e.g., to about 4000 Å). In other embodiments, shield dielectric layer 29 is composed of more than one dielectric material, such as one or more oxides, nitrides, and other dielectric materials known to one of ordinary skill in the art.

In some embodiments, gate dielectric 26 comprises one or more oxides, nitrides, tantalum pentoxide, titanium dioxide, barium strontium titanate, high-k dielectric materials, and/or other such materials known by those of ordinary skill in the art. In some embodiments, gate dielectric 26 comprises a thermal oxide having a thickness in a range of about 100 Å to about 1000 Å.

In some embodiments, shield electrodes 21 and gate electrodes 28 comprise doped polycrystalline semiconductor material, such as doped polysilicon. In some embodiments, the polysilicon is doped with N-type conductivity dopant, such as phosphorous or arsenic. In other embodiments, the polysilicon is doped with a P-type conductivity dopant, such as boron.

Semiconductor device 10 further includes body regions (also referred to as "base regions" or "PHV regions") 31, which in the illustrated embodiment comprise a P-type conductivity material, and are disposed adjacent to shielded-gate trench gate structures 13 as generally illustrated in FIG. 1. Each body region 31 may include a plurality of individually doped regions, or may be a continuous inter-connected doped region. In accordance with various embodiments, body regions 31 have a dopant concentration suitable for forming inversion layers that operate as a conduction channel or channel region for semiconductor device 10 when an appropriate bias voltage is applied to gate electrodes 28. Body regions 31 may extend from major surface 18 to a depth, for example, of about 0.7 microns to about 1.0 microns, and can be formed using a variety of doping techniques known in the art, such as ion implantation and annealing.

In some embodiments, source regions (also referred to as "current conducting regions" or "current carrying regions") 33 may be formed within, in, or overlying body regions 31, and may extend from major surface 18 to a depth of about 0.2 microns to about 0.4 microns. In some examples, source regions 33 have N-type conductivity formed using, for example, a phosphorous or arsenic dopant.

An ILD structure 41 may, in some embodiments, be formed overlying major surface 18. In one embodiment, ILD structure 41 comprises one or more dielectric or insulative layers, such as an undoped silicon glass (USG) layer having a thickness in a range of about 800 Å to about 100 Å, and a phosphorous doped silicon glass (PSG) layer having a thickness in a range of about 6000 Å to about 8000 Å. The PSG layer may have a phosphorous weight percentage in a range from about 3.0% to 5.0%. ILD structure 41 may be formed using chemical vapor deposition (CVD) or other such techniques known in the art. In some embodiments, ILD structure 41 is annealed to densify the structure. In some embodiments, ILD structure 41 is planarized using, for example, chemical mechanical planarization (CMP) techniques to provide a more uniform surface topography, thereby improving manufacturability.

Semiconductor device 10, in the illustrated embodiment, includes conductive regions 43 providing an electrical connection to source regions 33 and body regions 31, and similar conductive regions (not illustrated in FIG. 1) providing an electrical connection to shield electrodes 21. Conductive regions 43 provide contact to shield electrodes within the active area of semiconductor device 10, thereby reducing the resistance of shield electrodes 21 during device operation. In other embodiments, peripheral conductive regions are used in addition to, or in place of, conductive regions to establish electrical contact with shield electrodes 21. Stated another way, the structures and methods described herein are not limited to any particular method of providing electrical contact to shield electrodes 21.

Conductive regions 43 may be formed within contact openings (or "contact vias") 422 and are configured to provide electrical contact to source regions 33 and body regions 31 through contact regions (or "body enhancement regions") 36. In some examples, contact regions 36 are P-type conductivity when body regions 31 are configured as P-type conductivity. Contact regions 36 may be formed using various doping techniques, such as ion implantation processes and annealing processes. Similarly formed conductive regions (not shown in FIG. 1) can be used to provide electrical contact to shield electrodes 21.

In accordance with the present description, conductive regions 43 are electrically isolated from gate electrodes 28 by dielectric 53, which may take the form of dielectric spacers provided along sidewalls of contact openings 422. In some examples, dielectric 53 comprises one or more oxides, nitrides, organic dielectrics, and/or other insulative materials known to one of ordinary skill in the art.

Conductive regions 43 may be conductive plugs or other plug structures. In some embodiments, conductive regions 43 include a conductive barrier structure (or liner) and a conductive fill material. In some examples, the barrier structure includes a metal/metal-nitride configuration, such as titanium/titanium-nitride or other equivalent materials known to one of ordinary skill in the art. In other embodiments, the barrier structure includes a metal-silicide structure and/or tungsten. In some embodiments, conductive regions 43 are planarized to provide a more uniform surface topology.

A conductive layer 44 may be formed overlying major surface 18, and a conductive layer 46 may be formed overlying (on the underside of) major surface 19. Both of these conductive layers 44 and 46 are configured to provide electrical connection between the individual device components of semiconductor device 10, and toward that end can be formed from titanium, titanium-nitride, aluminum-copper, or other conductive materials known by one of ordinary skill in the art.

In the illustrated embodiment, conductive layer 44 is configured as an external source electrode. Shield electrodes 21 and source regions 33 may be electrically connected through conductive layer 44 such that they are at the same electrical potential when semiconductor device 10 is in use. Alternatively, shield electrodes 21 may be independently biased at an electrical potential that is selectively the same as, or different from, the electrical potential of source regions 33.

In accordance with various embodiments, as discussed in further detail below, semiconductor device 10 includes a semiconductor mesa overhang region 51 in which a lateral dimension (i.e., width) of body region 31 is substantially greater than the width of the drift region of semiconductor layer 14. In this way, the overlap of gate electrode 28 with semiconductor layer 14 (also referred to as gate-drain overlap) can be reduced or eliminated. This results in lower gate charge (Q_{g}), reduced Miller capacitance, lateral shrink, and reduced switching losses. That is, as previously discussed, conventional trench MOSFETs are prone to significant and overlap region in which the gate electrode is directly adjacent to the drain region of the MOSFET in a region that is separated only by the gate oxide. Such overlap significantly contributes to the parasitic gate-drain overlap capacitance (C_{gd}), which can result in switching losses and increased power dissipation. This issue has become more prominent as trench MOSFETs are scaled down due to, among other things, process variations relating to shield poly recess, shield oxide recess, and inter-poly-oxide recess etching. The structures and methods of the present disclosure address these and other unsatisfactory characteristics of prior art shielded-gate trench MOSFETs.

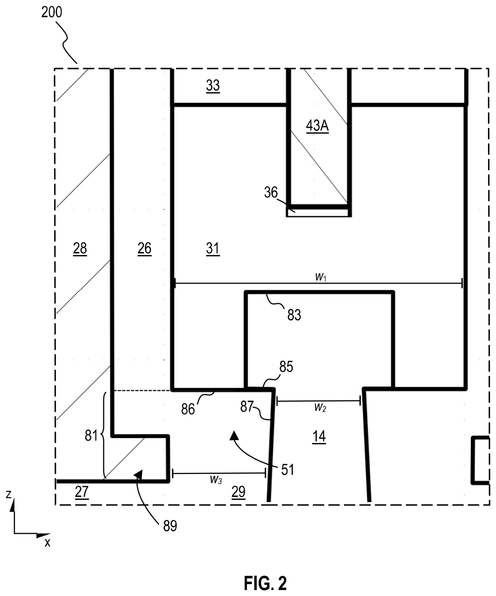

More particularly, referring now to FIG. 2 (which shows a close-up of region 200 of FIG. 1), the width *w₁* of body region 31 in the illustrated embodiment is substantially greater than the width *w₂* of semiconductor region 14 directly below the interface 86 between body region 31 and shield oxide layer 29 (also referred to as the "bottom edge" of body region 31), thereby forming an overhang region 51 in which the lateral distance *w₃* (along the x-axis, as defined in FIG. 2) between the gate electrode 28 and semiconductor region 14 is sufficient to reduce or eliminate gate-drain overlap. Stated another way, the width *w₃* of the dielectric material between the edge 87 of semiconductor region 14 and gate electrode 28 within region 81 (along the *z*-axis, as defined in FIG. 2) is substantially greater than the thickness of gate dielectric 26. In the illustrated embodiment, the bottom position of the P-well (upper extent of semiconductor region 14) 85 is substantially co-linear with interface ("bottom edge") 86, and therefore the gate inversion channel is formed, during operation, around the bottom corners of body region 31. Thus, any "overlap" of gate electrode 28 with semiconductor region 14 (i.e., the drain) occurs in a region where the dielectric material is significantly greater than the thickness of gate dielectric 26. This has been found to significantly reduce the Miller capacitance between gate electrode 28 and semiconductor region 14. In addition, a significant lateral shrink can be achieved due in part to the greater distance between the gate dielectric 26 and contact region 36.

In the illustrated embodiment, gate electrode 28 includes a region 89 that laterally extends inward (adjacent to the ILD layer 27) toward semiconductor region 14. The present disclosure is not limited to such embodiments, however; depending upon design considerations and selected processing details, gate electrode 28 may be fabricated without this feature, and may be substantially vertical. In other embodiments, region 81 of gate electrode 28 has any geometrical features configured to achieve the benefits described herein. That is, the present description is not limited to the particular shape of region 89 illustrated in the present figures.

More generally, the scale and geometric dimensions of FIG. 2 are not intended to be limiting, and a person of ordinary skill in the art will understand that such dimensions may be selected to achieve various design and performance objectives. In some embodiments, the geometry of overhang region is flexibly determined via a selective silicon epitaxial growth step (as described in further detail below) and is not constrained by the processing steps used to form shield oxide 29 and, furthermore, is not complicated by the use of SiN spacers or additional silicon etching steps.

In some embodiments, the width *w₂* of semiconductor region 14 is approximately 10% - 50% of the width *w₁* of body region 31. In other embodiments, width *w₂* is approximately 20% - 30% of width *w₁*. In some embodiments, width *w₂* is approximately 25% of width *w₁*. In some embodiments width *w₃* is 50% - 100% of the thickness of shield dielectric layer 29.

It will be appreciated by a person of ordinary skill in the art that the disclosed structures and methods result in a shielded-gate trench MOSFET that reduces or eliminates gate-drain overlap and thereby reduces parasitic gate-drain capacitance and switching losses. In addition, the disclosed designs and methods are cost-effective, result in a greater packing density and lateral shrink, and at the same time reduce the impact of process variation on gate-drain overlap and its deleterious effects.

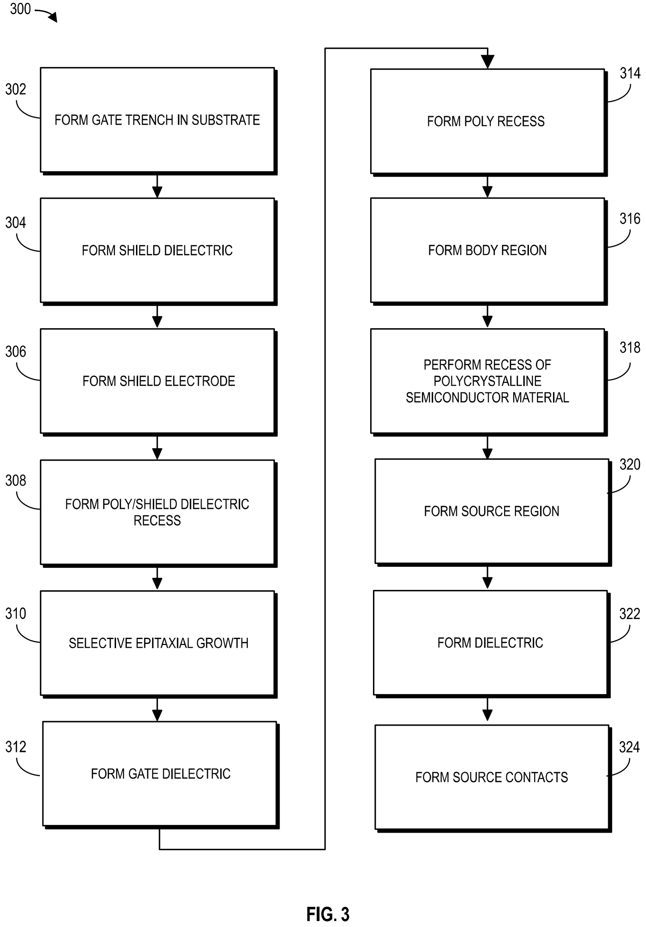

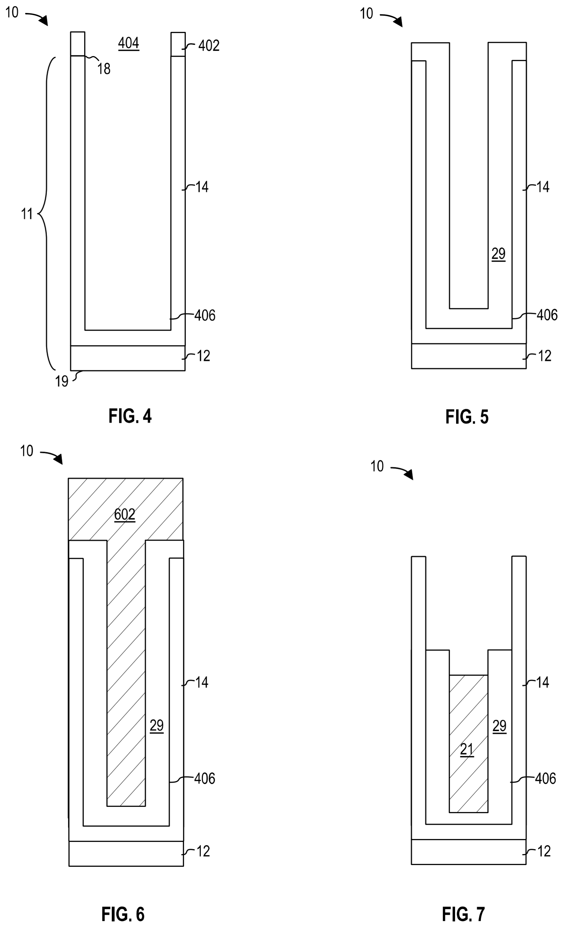

Having thus described semiconductor device 10 in accordance with various embodiments, a method of fabricating such a device will now be described in conjunction with the flowchart shown in FIG. 3 and the partial cross-sectional views depicted in FIGS. 4-11. Method 300 of FIG. 3 may be used to fabricate one or MOSFET implementations described herein, including, for example, the semiconductor device 10 of FIG. 1.

Referring now to FIG. 3, block 302 of method 300 includes forming a gate trench in a substrate, the result of which is illustrated in FIG. 4 at an early state of fabrication. More particularly, semiconductor region 11 may be provided as a semiconductor substrate or wafer, or another form of work piece. Semiconductor region 11 may first be cleaned, followed by forming a dielectric structure 402 over major surface 18. In some embodiments, dielectric structure 402 includes one or more layers of dielectric materials, such as thermal oxide, deposited nitrides, deposited oxides, or a combination thereof. A masking step (not illustrated) can then be used to form openings 404 in dielectric structure 402. A removal step, such as an etch step is then used to form active trench 406 extending from major surface 18 include a region of semiconductor material 11. Trenches 406 may be formed, for example, using plasma etching techniques with a fluorocarbon chemistry or fluorinated chemistry (e.g., SF₆/O₂) or other chemistries or removal techniques known to those of ordinary skill in the art. In some embodiments, trench 406 has a depth in a range of about 0.5 microns to 9.0 microns. After trenches 406 are formed, the exposed surfaces of the trenches 406 may be cleaned using, for example, a buffered hydrofluoric acid (HF) clean. In some embodiments, dielectric structure 402 can then be removed.

Block 304 of method 300 includes forming a shield dielectric layer, the result of which is illustrated in FIG. 5. More particularly, shield dielectric layer 29 is provided along the surfaces of trench 406 using, for example, suitable masking techniques. In some examples, shield dielectric layer 29 comprises a thermal oxide having a thickness in a range of about 800 Å to about 1050 Å. The thickness of shield dielectric layer 29 can be selected depending upon, among other factors, the electrical requirements of semiconductor device 10. For example, the thickness of shield dielectric layer 29 may be about 4000 Å for higher voltage devices. In some embodiments, shield dielectric layer 29 may comprise ore than one dielectric material, such as various oxides, nitrides, or combination thereof, or other dielectric materials known to one of ordinary skill in the art.

Block 306 of method 300 includes the first step in forming the polysilicon shield electrodes, the result of which is illustrated in FIG. 6. That is, a polycrystalline semiconductor material 602 is formed within shield dielectric layer 29, as shown. In some embodiments, polycrystalline semiconductor layer 602 includes polysilicon, which can be doped with an N-type conductivity dopant either in situ or after formation of polycrystalline semiconductor layer 602. In some embodiments, chemical vapor deposition (CVD) techniques are used to form polycrystalline semiconductor layer 602. Alternatively, other deposition techniques, such as plasma-enhanced CVD (PECVD), may be employed. In some embodiments, polycrystalline semiconductor layer 602 has a thickness in the range of about 400 Å to about 700 Å. This thickness may be selected depending upon, among other factors, the gap distance between shield dielectric 29. In some embodiments, layer 602 may comprise a metal, a metalloid, and/or other conductive material known to one of ordinary skill in the art. In some embodiments, layer 602 may include, for example, tungsten (W), titanium-nitride (TiN), tantalum (Ta), tantalum-nitride (TaN), and/or palladium (Pd), either as a mixture or in a laminate structure.

Block 308 of method 300 includes performing shield poly/shield dielectric recess processes, the result of which is illustrated in FIG. 7. That is, an upper portion of both shield dielectric layer 29 and polycrystalline semiconductor material 602 are removed using suitable etching and photolithography steps as known by a those of ordinary skill in the art. As illustrated, the height of shield dielectric layer 29 is greater than the height of polycrystalline semiconductor material 602 within trench 406 by an offset distance that may be selected in accordance with various design parameters, including for example the desired thickness of the interlayer dielectric (27 in FIG. 1). In some embodiments, an anisotropic etch is used to remove portions of polycrystalline semiconductor layer 602. In others, a dry etch process is used with a chemistry having a high selectivity to etch polycrystalline semiconductor layer 602 at a higher rate than shield dielectric layer 29. In some examples, a chlorine (Cl) and/or bromine (HBr) based chemistry is utilized for this purpose.

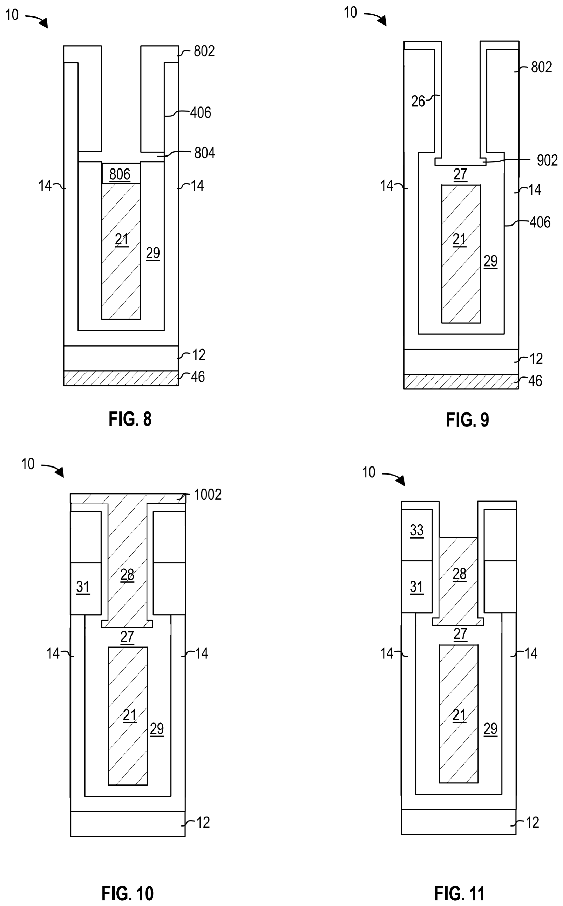

Block 310 of method 300 includes performing selective epitaxial growth to form what will become part of the body region and source region of the finished semiconductor device 10 (31 and 33 in FIG. 1). More particularly, referring to FIG. 8, a semiconductor epitaxial layer 802 is formed on top of and along at least a portion of the inner walls of trench 406. In some embodiments, epitaxial layer 802 is formed using a selective epitaxial growth (SEG) process in which the crystalline semiconductor material (e.g., silicon) is grown on exposed regions while growth is prevented on other regions, which are typically covered by a dielectric mask (e.g., silicon dioxide or silicon nitride) such as region 806 covering shield electrode 21 in FIG. 8. The epitaxially grown material 802 itself may comprise a variety of semiconductor materials, such as silicon or a range of III-V compounds (e.g., GaAs, InP, InAs, InSb, etc.). Such materials may be doped as desired in situ or post-growth. Epitaxial layer 802 may be formed, for example, using chemical vapor deposition (CVD), molecular beam epitaxy (MBE), metalorganic vapor phase epitaxy (MOVPE), chemical beam epitaxy (CBD), or other such processes known by one of ordinary skill in the art. In some embodiments, after further processing, a gap 804 remains between epitaxial layer 802 and shield dielectric layer 29. This gap or voided region may be accomplished using a variety of photolithographic techniques and/or sacrificial layers as known by those of ordinary skill in the art. In accordance with one embodiment, gap 804 (for embodiments including such a gap) is the result of using an epitaxial growth process that is facet-dependent and/or crystal orientation-dependent.

Block 312 of method 300 includes forming a gate dielectric layer, the result of which is illustrated in FIG. 9. That is, a dielectric layer 26 is formed over epitaxial layer 802 as shown. Gate dielectric layer 26 may comprise various oxides, nitrides, tantalum pentoxide, titanium dioxide, barium strontium titanate, high-k dielectric materials, combinations thereof, or other related or equivalent materials known by one of ordinary skill in the art. In some embodiments, gate dielectric layer 26 includes a thermal oxide having a thickness in a range from about 100 Å to about 1000 Å. In some embodiments, a high-temperature oxide (HTO) layer may be formed over gate dielectric layer 26, which may have a thickness in the range of about 75 Å to about 150 Å. In some embodiments, due to the presence of gaps 804 as illustrated in FIG. 8, inclusions 902 may be formed, projecting laterally toward the sidewalls of trench 406 as shown. In some embodiments, depending upon dimensional considerations and processing details, gaps 804 are not present.

Block 314 of method 300 includes providing of a layer of polycrystalline material 1002 as shown, which will ultimately form polysilicon gate electrode 28. The result of this process is illustrated in FIG. 10. In some embodiments, polycrystalline semiconductor layer 1002 comprises polysilicon, which can be doped with an N-type conductivity dopant either in-situ or after formation. In some embodiments, chemical vapor deposition (CVD) techniques, such as plasma-enhanced CVD (PECVD), are used. In some examples, layer 1002 comprises other materials that can be deposited in a conformal layer using CVD, metal-organic CVD (MOCVD), atomic layer deposition (ALD), and other such processes. Such materials may include tungsten, titanium-nitride, tantalum, tantalum-nitride, palladium, or other materials known by one of ordinary skill in the art.

Next, in block 316, body region 31 is formed as depicted in FIG. 10. In some examples, photo-masking steps are used to provide the desired patterns for body region 31, followed by ion implantation and anneal processes configured to form the doped region (e.g., using P-type dopants to form a "P-well" within body 31).

Block 318 of method 300 includes performing a recess of polycrystalline semiconductor material 1002 to form gate electrode 28. The result of these steps is illustrated in FIG. 11. As described above, this recess may be accomplished using suitable etching and photolithography steps as known by a those of ordinary skill in the art. As illustrated, the height of gate electrode 28 is above the upper extend of body region 31; however, the invention is not so limited. The dimensions of gate electrode 28 may be chosen to achieve a range of design criteria, including electrical performance. In some embodiments, an anisotropic etch is used to remove portions of polycrystalline semiconductor layer 1002. In others, a dry etch process is used with a chemistry having a high selectivity to etch polycrystalline semiconductor layer 1002 at a higher rate than gate dielectric layer 26.

Next, block 320 of method 300 includes formation of the source region 33 above body region 31, as shown in FIG. 11. This step may include photo-masking steps used to provide the desired patterns for source region 33, followed by ion implantation and anneal processes configured to form region 33 with the desired dopant level and dimensions (e.g., using N-type dopants). It will be appreciated that the formation of source region 33, as well as body region 31, may be accomplished at a variety of other processing steps, and therefore the particular method 300 shown in FIG. 3 is not intended to be limiting.

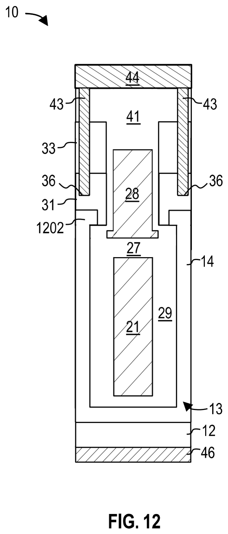

Next, processing continues with the formation of a topside dielectric (block 322) and source contacts (block 324), the results of which are illustrated in FIG. 12. That is, referring to FIG. 12, one or more dielectric materials 41 are formed over gate electrode 28 and source region 33 as illustrated. Dielectric material 41 may comprise one or more dielectric layers, such as an undoped silicon glass and/or boron-doped silicon glass (BSG) formed by CVD or similar techniques.

Next, as shown in FIG. 12, conductive regions 43 may be formed within contact openings (422 in FIG. 1) to provide electrical contact to source regions 33 and body regions 31 through contact regions (or "body enhancement regions") 36. In some examples, contact regions 36 are P-type conductivity when body regions 31 are configured as P-type conductivity. In addition, an "N-Link" process may be performed to alter the doping of the semiconductor material 14 in region 1202 (extending upward, for example, from interface 86 in FIG. 2). For example, a region of N-type doping concentration may be provided in region 1202 (e.g., through ion implantation techniques) through the opening provided through contact regions 36, resulting in an N-type region that extends upward into the P-type body 31 and is partially encompassed by body 31 as shown. The resulting region 1202 is referred to herein as an "N-link" region. The doping concentration of N-link region 1202 may be selected based on, for example, the desired electrical characteristics. Contact regions 36 may be formed using various doping techniques, such as ion implantation processes and annealing processes. A conductive layer 44 may be formed overlying major surface 18, and a conductive layer 46 may be formed overlying (on the underside of) major surface 19. Both of these conductive layers 44, 46 are configured to provide electrical connection between the individual device components of semiconductor device 10, and toward that end can be formed from titanium, titanium-nitride, aluminum-copper, or other conductive materials known by one of ordinary skill in the art.

In the illustrated embodiment, conductive layer 44 is configured as an external source electrode. Shield electrodes 21 and source regions 33 may be electrically connected through conductive layer 44 such that they are at the same electrical potential when semiconductor device 10 is in use. Alternatively, shield electrodes 21 may be independently biased at an electrical potential that is selectively the same as, or different from, the electrical potential of source regions 33.

A semiconductor device in accordance with various embodiments comprises: a region of semiconductor material comprising a first major surface and a first conductivity type, and and a trench gate structure. The trench gate structure includes: a trench extending from the first major surface into the region of semiconductor material; a shield dielectric layer adjacent to a lower portion of the trench; a shield electrode adjacent to the shield dielectric layer in the lower portion of the active trench, the shield electrode comprising a first polycrystalline semiconductor material; a gate dielectric layer adjacent to an upper portion of the trench; a gate electrode adjacent to the gate dielectric layer in the upper portion of the active trench, the gate electrode comprising a second polycrystalline semiconductor material; and a gate conductive layer adjacent to the gate electrode; a dielectric fill structure in the trench electrically isolating the gate electrode and the gate conductive layer from the shield electrode. The semiconductor device further includes a body region of a second conductivity type opposite that of the first conductivity type in the region of semiconductor material extending from the major surface adjacent to the trench gate structure, wherein the body region comprises at least a portion of epitaxially grown semiconductor material forming a semiconductor mesa overhang region such that a width of the body region above the semiconductor mesa overhang region is substantially greater than a width of the semiconductor material below the semiconductor mesa overhang region. The semiconductor device further includes a source region of the first conductivity type adjacent to the body region.

In accordance with one embodiment, the gate electrode includes a laterally extending region below a bottom edge of the body region.

In accordance with one embodiment, the gate electrode below the semiconductor mesa overhang region is separated from the semiconductor material by a lateral distance that is greater than a thickness of the gate dielectric layer. In accordance with one embodiment, the lateral distance is approximately equal to a thickness of the shield dielectric layer.

In accordance with one embodiment, the width of the body region below the semiconductor mesa overhang region is approximately 10%-50% of the width of the body region above the semiconductor mesa overhang region.

In accordance with one embodiment, the semiconductor device further includes an N-link region of the first conductivity type extending upward into a portion of the body region.

While the subject matter of the present invention is described in the context of specific examples, the foregoing drawings and description depict only typical examples of the subject matter, and are not therefore to be considered limiting of its scope. Many alternatives and variations will be apparent to those skilled in the art. For example, materials described for the gate electrodes, shield electrodes, gate conductive layers, and shield conductive layers may comprise one or more materials. When a plurality of materials are used, the materials may be deposited in sequence to provide a laminated structure. Alternatively, a first layer may be deposited and patterned (for example, a first spacer portion), and subsequent layers deposited and patterned in a similar manner. Conductive materials for the gate and shield structures may include polycrystalline semiconductor materials, silicides, metals, metal-nitrides, metalloids, and other conductive materials as known to one of ordinary skill in the art. Various deposition techniques may be used to deposit such materials, including CVD, PECVD, MOCVD, ALD, as well as other deposition techniques known to one of ordinary skill in the art.

For simplicity and clarity of the illustration, elements in the figures are not necessarily drawn to scale, and the same reference numbers in different figures denote the same elements. Similarly, certain regions of device structures, such as doped regions or dielectric regions, may be illustrated as rectilinear with generally straight-line edges and precise angular corners. However, those skilled in the art will understand that, due to the diffusion and activation of dopants or formation of layers, the edges of such regions generally may not be straight lines and that the corners may not be precise angles. Additionally, descriptions and details of well-known steps and elements are omitted for simplicity of the description.

Although the semiconductor devices are described herein as certain N-type conductivity regions and certain P-type conductivity regions, a person of ordinary skill in the art will understand that such conductivity types may be reversed in accordance with the present description, taking into account any necessary polarity reversal of voltages, inversion of transistor type, and the like.

As used herein, "current-carrying electrode" means an element of a device that carries current through the device, such as a source or a drain of an MOS transistor, an emitter or a collector of a bipolar transistor, or a cathode or anode of a diode, and a "control electrode" means an element of the device that controls current through the device, such as a gate of a MOS transistor or a base of a bipolar transistor.

The term "major surface" when used in conjunction with a semiconductor region, wafer, or substrate means the surface of the semiconductor region, wafer, or substrate that forms an interface with another material, such as a dielectric, an insulator, a conductor, or a polycrystalline semiconductor. The major surface can have a topography that changes in the x, y and z directions.

The terms "comprises," "comprising," "includes," and/or "including," as used herein, are open ended terms that specify the presence of stated features, numbers, steps, operations, elements, and/or components, but do not preclude the presence or addition of one or more other features, numbers, steps, operations, elements, components, and/or groups thereof. The term "or" means any one or more of the items in the list joined by "or." As an example, "x or y" means any element of the three-element set {(x), (y), (x, y)}. As another example, "x, y, or z" means any element of the seven-element set {(x), (y), (z), (x, y), (x, z), (y, z), (x, y, z)}. As used herein, the singular forms are intended to include the plural forms as well, unless the context clearly indicates otherwise. Similarly, the phrases "for example" and "e.g." are intended to be nonlimiting.

Although ordinal terms such as "first", "second", and "third" may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

It will be appreciated by one skilled in the art that words such as "during," "while," and "when" as used herein with respect to circuit operation are not intended as exact terms indicating that an action takes place instantly or simultaneously upon an initiating action, but that there may be some small but reasonable delay, such as propagation delay, between the reaction that is initiated by the initial action. Additionally, the term "while" means a certain action occurs at least within some portion of a duration of the initiating action.

The use of word "about," "approximately," or "substantially" means a value of an element is expected to be close to a state value or position. However, as is well known in the art, there are always minor variances preventing values or positions from being exactly stated.

As used herein, the terms "exemplary embodiment," "example embodiment," "present embodiment," "one embodiment," and the like do not necessarily refer to a single embodiment, and various example embodiments may be readily combined and interchanged without departing from the scope or spirit of the present invention. As used herein, the word "exemplary" means "serving as an example, instance, or illustration," and does not connote a preferred or advantageous implementation.

The term "horizontal" as used herein refers to a plane parallel to the conventional plane or surface of a wafer or substrate. The term "vertical" refers to a direction orthogonal or perpendicular to the horizontal plane. Prepositions, such as "on," "side" (as in sidewall), "below," "above," "above," "higher," "lower," "over," and "under" are defined with respect to the conventional plane or surface being on the top surface of the wafer or substrate, regardless of the orientation of the wafer or substrate. It will be understood that these terms are intended to encompass different orientations of the device in addition to the orientation depicted in the figures.

Unless specified otherwise, as used herein, the word "over" or "on" includes orientations, placements, or relations where the specified elements can be in direct or indirect physical contact. Unless specified otherwise, as used herein, the word "overlapping" includes orientations, placements, or relations where the specified elements can at least partly or wholly coincide or align in the same or different planes.

As the claims hereinafter reflect, inventive aspects may lie in less than all features of a single foregoing disclosed example. Thus, the claims below are hereby expressly incorporated into this Detailed Description, with each claim standing on its own as a separate example of the invention. Furthermore, while some examples described herein include some, but not other features included in other examples, combinations of features of different examples are meant to be within the scope of the invention and meant to form different examples as would be understood by those skilled in the art.

## Claims

1. A semiconductor device comprising:
a region of semiconductor material comprising a first major surface and a first conductivity type;
a trench gate structure comprising:
a trench extending from the first major surface into the region of semiconductor material;
a shield dielectric layer adjacent to a lower portion of the trench;
a shield electrode adjacent to the shield dielectric layer in the lower portion of the active trench, the shield electrode comprising a first polycrystalline semiconductor material;
a gate dielectric layer adjacent to an upper portion of the trench;
a gate electrode adjacent to the gate dielectric layer in the upper portion of the active trench, the gate electrode comprising a second polycrystalline semiconductor material;
a gate conductive layer adjacent to the gate electrode;
a dielectric fill structure in the trench electrically isolating the gate electrode and the gate conductive layer from the shield electrode;
a body region of a second conductivity type opposite that of the first conductivity type in the region of semiconductor material extending from the major surface adjacent to the trench gate structure, wherein the body region has a bottom edge, and a width of the body region above the bottom edge is substantially greater than a width of the semiconductor material below the bottom edge; and
a source region of the first conductivity type adjacent to the body region.

2. The semiconductor device of claim 1, wherein the gate electrode includes a laterally extending region below the bottom edge of the body region.

3. The semiconductor device of claim 1, wherein the gate electrode below the bottom edge of the body region is separated from the semiconductor material by a lateral distance that is greater than a thickness of the gate dielectric layer.

4. The semiconductor device of claim 3, wherein the lateral distance is approximately equal to a thickness of the shield dielectric layer.

5. The semiconductor device of claim 1, wherein the body region comprises at least a portion of epitaxially grown semiconductor material.

6. The semiconductor device of claim 1, wherein the body region includes an overhang region relative to the semiconductor material below the bottom edge of the body region.

7. The semiconductor device of claim 1, further including an N-link region of the first conductivity type extending upward into a portion of the body region.

8. A method of forming a semiconductor device, comprising:
providing a region of semiconductor material comprising a first major surface and a first conductivity type;
providing a trench gate structure comprising:
a trench extending from the first major surface into the region of semiconductor material;
a shield dielectric layer adjacent to a lower portion of the active trench;
a shield electrode adjacent to the shield dielectric layer, the shield electrode comprising a first polycrystalline semiconductor material;
a gate dielectric layer adjacent to an upper portion of the active trench;
a gate electrode adjacent to the gate dielectric layer, the gate electrode comprising a second polycrystalline semiconductor material;
a gate conductive layer adjacent to the gate electrode;
a dielectric fill structure in the active trench electrically isolating the gate electrode and the gate conductive layer from the shield electrode;
providing a body region of a second conductivity type opposite the first conductivity types in the region of semiconductor material extending from the major surface adjacent to the trench gate structure; wherein the body region has a bottom edge, and a width of the body region above the bottom edge is substantially greater than a width of the semiconductor material below the bottom edge;
and
providing a source region of the first conductivity type in the body region adjacent to the trench gate structure.

9. The method of claim 8, wherein the gate electrode is formed to include a laterally extending region below the bottom edge of the body region.

10. The method of claim 8, wherein the gate electrode is formed such that a portion of the gate electrode below the bottom edge of the body region is separated from the semiconductor material by a lateral distance that is greater than a thickness of the gate dielectric layer.

11. The method of claim 10, wherein the lateral distance is approximately equal to a thickness of the shield dielectric layer.

12. The method of claim 8, wherein the body region is at least partially formed from epitaxially grown semiconductor material.

13. The method of claim 8, wherein the body region is formed to include an overhang region relative to the semiconductor material below the bottom edge of the body region.

14. The method of claim 8, further including forming an N-link region of the first conductivity type extending upward into a portion of the body region.

15. The method of claim 14, wherein the N-link region is formed using ion-implantation.
